# EUROPÄISCHE PATENTSCHRIFT

(11) **EP 0 598 762 B1**
(45) Veröffentlichungstag und Bekanntmachung des Hinweises auf die Patenterteilung: **20.09.1995**
(21) Anmeldenummer: 92916257.6
(22) Anmeldetag: 23.07.1992
(51) Int. Cl.: C04B 41/89, C23C 28/00, C23C 16/40

(54) **WERKZEUG MIT VERSCHLEISSFESTER SCHNEIDE AUS KUBISCHEM BORNITRID ODER POLYKRISTALLINEM KUBISCHEM BORNITRID, VERFAHREN ZU DESSEN HERSTELLUNG SOWIE DESSEN VERWENDUNG**
TOOL WITH WEAR-RESISTANT CUTTING EDGE MADE OF CUBIC BORON NITRIDE OR POLYCRYSTALLINE CUBIC BORON NITRIDE, A METHOD OF MANUFACTURING THE TOOL AND ITS USE
OUTIL A TRANCHANT RESISTANT A L'USURE EN NITRURE DE BORE CUBIQUE OU EN NITRURE DE BORE CUBIQUE POLYCRISTALLIN, PROCEDE DE FABRICATION ET UTILISATION

(30) Priorität: 14.08.1991 DE 4126851
(43) Veröffentlichungstag der Anmeldung: 01.06.1994
(73) Patentinhaber: Widia GmbH, 45145 Essen (DE)
(72) Erfinder: KÖNIG, Udo, D-4300 Essen 1 (DE); TABERSKY, Ralf, D-4250 Bottrop (DE)
(74) Vertreter: Vomberg, Friedhelm, Dipl.-Phys.
(86) Internationale Anmeldenummer: DE9200608
(87) Internationale Veröffentlichungsnummer: WO9304015

(56) Entgegenhaltungen:
- EP-A- 0 209 137
- DERWENT ACCESSION No. 85-233 949, Questel Telesystems, WPIL, DERWENT PUBLICATIONS LTD., London, siehe Zusammenfassung
- DERWENT ACCESSION no. 74-61 159, Questel Telesystems, WPI, DERWENT PUBLICATIONS LTD., London, siehe Zusammenfassung

## Beschreibung

Die Erfindung betrifft ein Werkzeug mit verschleißfester Schneide aus kubischem Bornitrid oder polykristallinem kubischem Bornitrid, wobei mindestens die Oberfläche des Werkzeuges ganz oder teilweise aus kubischem Bornitrid oder polykristallinem kubischem Bornitrid besteht, ein Verfahren zu dessen Herstellung sowie dessen Verwendung.

Es ist seit langem bekannt, zur spanenden Bearbeitung von besonders harten Werkstoffen, beispielsweise harten Eisen- und Stahlwerkstoffen, Werkstoffen für Warm- und Kaltwalzen, Gußwerkstoffe und dgl., Werkzeuge aus polykristallinem kubischem Bornitrid (PCBN) zu verwenden.

Neben den häufig verwendeten Monoblocks aus massivem PCBN, die in verschiedenen Formen angeboten Werden und in der Regel in den Werkzeughalter geklemmt sind, sind auch einlötbare PCBN-Schneideinsätze (Inlays) verfügbar. Diese PCBN-Schneideinsätze Weisen eine einseitig metallisierte Fläche auf, die das Einlöten, meist Hartlötung bei 660 °C bis 840 °C, in einen Werkzeugträger ermöglicht.

Es sind auch schon Versuche unternommen worden, kubisches Bornitrid (CBN) durch CVD- (chemical vapor deposition), PVD-(physical vapor deposition) oder plasmaaktivierte CVD-Verfahren direkt aus der Gasphase auf einen Substratkörper abzuscheiden.

So wird beispielsweise in der EP 0 209 137 vorgeschlagen, auf ein Substrat, das mit einer Zwischenschicht aus mindestens einem Nitrid und/oder Oxinitrid der Metalle Aluminium, Gallium, Indium und Tellur versehen ist, eine Schicht aus orientiert wachsendem kubischem Bornitrid (CBN) aus der Gasphase abzuscheiden.

Die physikalischen Eigenschaften des CBN, insbesondere die hohe thermische Stabilität, gewährleisten, daß auch schwierig zu zerspanende Werkstoffe durch Drehen, Bohren und Fräsen mit hohem Zeitspanvolumen und erheblichen Standzeiten bearbeitet werden können.

Nach K. Steinmetz (VDI-Z., Band 192 (1987), Nr. 2, Seite 64 bis 69) ist es jedoch ein Nachteil der aus PCBN bestehenden Werkzeuge, daß insbesondere bei der Fertigbearbeitung von Werkstücken aus harten Eisenwerkstoffen, also bei kleineren Spanungsquerschnitten, ein erheblicher Schneidenverschleiß auftritt, so daß Maß-, Form- und Oberflächenendqualitäten nicht eingehalten werden können.

Dieser Effekt ist vor allem auf die hohe Wärmeleitfähigkeit der aus PCBN bzw. CBN bestehenden Werkzeuge zurückzuführen.

Steinmetz hat deshalb für solche Zerspanungsvorgänge die Verwendung eines PCBN mit keramischer Bindephase vorgeschlagen. Infolge der durch die geänderte Zusammensetzung verminderten Wärmeleitfähigkeit wird ein größerer Teil der Zerspanungswärme für die Spanerweichung genutzt, so daß beim Feindrehen harter stahlbauteile bessere Ergebnisse erreicht werden konnten

Aus JP 61-41768 A. In: Patents Abstracts of Japan, C-359, July 11, 1986, Vol. 10, No. 199, ist es bekannt, unter vermeidung einer geschlossenen Schicht einzelne kubische BN-Kristalle auf einem Hartmetallegierungs-, einem Cermet- oder einem Keramik-Substrat in einer Höhe von 0,1 bis 10 µm abzuscheiden und die Bornitrid-freien Zwischenräume mit Carbiden, Nitriden, Carbonitriden, Boriden, Bornitriden, Oxiden und Oxicarbiden der IVa- bis VIa-Elemente, hexagonalem BN, amorphem BN und Al₂O₃ aufzufüllen, Nachteiligerweise reichen die singulären Bornitrid-Teilchen jedoch nicht aus, um eine gute Schneidwirkung zu erzeugen. Weiterhin können thermische Spannungen beim Abkühlen infolge der unterschiedlichen Wärmeausdehnungskoeffizienten von Bornitrid und Al₂O₃ auftreten, was zu Rißbildungen führen kann. Schließlich neigen die BN-Teilchen auch unter Beanspruchung zum Ausbrechen.

Es ist bekannt, verschleißfeste Beschchtungen nach dem CVD-Prozeß durch Gasphasenreaktionen bei hohen Temperaturen direkt auf das Substrat abzuscheiden. Daneben sind plasmaaktivierte CVD-Verfahren bekannt, die bei niedrigeren Gasphasentemperaturen arbeiten.

Beispielsweise wird in der DE 38 41 730 und der DE 38 41 731 ein Puls-Plasma-CVD-Verfahren zum Beschichten eines metallischen Grundkörpers mit einem nichtleitenden Beschichtungsmaterial, insbesondere Al₂O₃, beschrieben, bei dem an den als Kathode geschalteten Grundkörper eine gepulste Gleichspannung von 200 bis 900 Volt mit einer Pulsdauer von 50 µs angelegt wird, wobei in den Pulspausen von 80 µs eine Restspannung erhalten bleibt, die größer als das niedrigste Ionisierungspotential der am CVD-Prozeß beteiligten Moleküle, jedoch nicht größer als 50 % der maximalen Spannung ist, und bei dem die Beschichtung bei Gasphasentemperaturen zwischen 400 °C und 800 °C durchgeführt wird.

Der Erfindung liegt nun die Aufgabe zugrunde, ein Werkzeug mit verschleißfester Schneide aus CBN oder PCBN zu schaffen, dessen Schneidkantenstabilität unter Vermeidung der obengenannten Nachteile erheblich verbessert ist.

Es ist ferner Aufgabe der vorliegenden Erfindung, ein Verfahren zur Herstellung des erfindungsgemäßen Werkzeuges anzugeben.

Schließlich ist es Aufgabe der vorliegenden Erfindung, die Verwendung des erfindungsgemäßen Werkzeuges anzugeben.

Die der Erfindung zugrundeliegende Aufgabe wird durch das Werkzeug nach Anspruch 1 gelöst, bei dem eine sich ganz oder teilweise über das Werkzeug erstreckende geschlossene CBN- oder PCBN-Schicht mit einer dünnen Schicht aus einem oder mehreren Metalloxiden überzogen ist.

Die Dicke der Oxid-Schicht beträgt 0,5 bis 6 µm, vorzugsweise 1 bis 3 µm, und/oder die CBN- oder PCBN-Schicht bis 10 mm. Die Oxidschicht ist nach einer weiteren Ausgestaltung der Erfindung feinkristallin und/oder rißfrei.

Für die Oxid-Schicht werden die Oxide der Metalle Zirkonium und/oder Yttrium und/oder Magnesium und/oder Titan und/oder Aluminium verwendet. Vorzugsweise werden Schichten aus Aluminiumoxid aufgebracht.

Überraschenderweise hat sich nämlich gezeigt, daß ein derartig gestaltes Werkzeug nicht nur hervorragende Verschleißeigen-schaften aufweist, sondern aufgrund der hohen Schneidkantenstabilität sogar zur spanenden Feinbearbeitung von harten Werk-Stoffen, insbesondere von harten Eisen- und Stahlwerkstoffen geeignet ist.

Die einzelnen Kristalle des PCBN werden durch ein metallisches Bindemittel (z.B. Eisen, Nickel, Cobalt), das auch Bestandteile an Hartstoffen erhalten kann (z.B. TiC), unter Hochdruck zu einem massivem Körper verbunden. Da sich PCBN weitgehend inert verhält, reagiert der bei der Zerspanung an die heiße Schneid-körperoberfläche herantretende Luftsauerstoff vorzugsweise mit den metallischen Bestandteilen des Bindemittels und bildet Oxide, z.B. (Eisenoxid, Nickeloxid, Cobaltoxid), die die Funktion eines Binders zwischen den CBN-Körnern wegen unzureichender mechanischer Eigenschaft (z.B. Duktilität, Benetzungsvermögen) nicht mehr erfüllen können. Es kann daher zum Herauslösen einzelner CBN-Körner während der Beanspruchung beim Zerspanen kommen, wodurch die Stabilität der Schneidkante vermindert und infolge dessen der mechanische Schneidenverschleiß erheblich verstärkt wird.

Dieser Effekt tritt umso stärker auf, je mehr Zerspanungswärme in den Schneidkörper abgeleitet wird. Da mit sinkendem Spanungsquerschnitt der Anteil der Zerspanungswärme, der für die Spanerweichung genutzt werden kann, abnimmt, tritt ein verstärkter Schneidenverschleiß bzw. eine verminderte Schneidenstabilität, insbesondere bei der Feinbearbeitung auf. Durch die bei der spanenden Bearbeitung von harten Eisen- und Stahlwerkstoffen auftretenden hohen Zerspanungstemperaturen wird dieser Effekt zusätzlich verstärkt.

Wird das PCBN mit einer dünnen Schicht aus Oxid überzogen, wird der Zutritt des Luftsauerstoffes zum Bindemittel weitgehend verhindert, so daß die im Bindemittel enthaltenen Metalle kaum noch Oxide bilden.

Nach einer besonders vorteilhaften Ausgestaltung der Erfindung wird die erfindungsgemäße Oxid-Schicht auf ein Werkzeug mit einem Einsatz aus einseitig metallisiertem PCBN aufgetragen.

Nach einer weiteren Ausgestaltung der Erfindung wird die erfindungsgemäße Oxid-Schicht auf einen massiven Körper aus PCBN (Mononblock) abgeschieden.

Schließlich können auch Verbundkörper, die mit CBN beschichtet sind, wobei sich zwischen der CBN-Schicht und dem Substrat auch eine CBN-freie Zwischenschicht befinden kann, mit der erfindungsgemäßen Oxid-Schicht beschichtet werden.

Die Zwischenschicht besteht aus mindestens einem Nitrid und/oder Oxinitrid der Metalle Aluminium, Gallium, Indium oder Tellur, vorzugsweise wird Aluminiumnitrid verwandt.

Als Substratkörper werden Hartmetalle oder Schneidkeramiken oder Siliziumnitrid oder Silizium-Aluminium-Oxinitrid oder Cermets order werkzeugstähle verwandt.

Die in den verschiedenen Ausführungsformen der Erfindung verwandten PCBN enthalten 0 bis 50 Gew.-%, vorzugsweise 10 bis 25 Gew.-%, Bindemittel. Als Bindemittel werden Cobalt, Nickel, Wolfram und andere Metalle, vorzugsweise Cobalt, verwandt.

Nach einer weiteren, besonders vorteilhaften Ausgestaltung der Erfindung wird die Oxid-Schicht nicht auf die gesamte mit CBN oder PCBN bedeckte Fläche abgeschieden, sondern nur dort, wo die CBN- oder PCBN-Schneide dem Verschleiß tatsächlich ausgesetzt ist, so daR das PCBN bzw. die CBN-Schicht nur teilweise mit der Oxid-Schicht bedeckt ist.

Die der Erfindung zugrundeliegende Aufgabe wird ferner durch ein Verfahren zur Herstellung des Werkzeuges mit verschleißfester CBN- oder PCBN-Schneide gelöst, nachdem die verschleißmindernde Schicht, bestehend aus einem oder mehreren Metalloxiden, auf das CBN oder PCBN bei Gasphasentemperaturen bis zu 800 °C aufgebracht wird. Vorzugsweise beträgt die Gasphasentemperatur 400 °C bis 600 °C.

Weiterhin können mit dem erfindungsgemäßen Verfahren Oxid-Schichten hergestellt werden, die einen sehr guten Verbund zum Substrat haben und völlig frei von Rissen sind.

Der besondere Vorteil des erfindungsgemäßen Verfahrens besteht darin, daß Werkzeuge mit eingelöteten oder eingeklebten Inlays als komplettes Werkzeug, d.h., mit bereits befestigten PCBN beschichtet werden können, da bei dem erfindungsgemäßen Beschichtungsverfahren die Gasphasentemperaturen so gewählt werden können, daß die Schutztemperatur des Lotes oder Klebstoffes nicht überschritten wird.

Durch diese Maßnahme wird insbesondere vermieden, daß die aufgebrachte Oxid-Schicht bei dem sonst erforderlichen nachträglichen Einbau beschädigt wird.

Nach der Erfindung ist es deshalb besonders vorteilhaft, zur Herstellung der Oxid-Schicht plasmaaktiviorte CVD-Verfahren, insbesondere das Puls-Plasma-CVD-Verfahren, anzuwenden.

Bei Anwendung des Puls-Plasma-CVD-Verfahrens konnten bei Einstellung folgender Versuchsparameter besonders gute Ergebnisse bei der Herstellung von Oxid-Schichten erzielt werden:

| | |
|---|---|
| Temperatur der Gasphase: | 400 °C bis 600 °C |
| Gleichspannung: | - 300 V bis -600 V |
| Restspannung: | - 20 V bis - 60 V |
| Pulsdauer: | 30 µs bis 60 µs |
| Pulspause: | 40 µs bis 100 µs |

Der zu beschichtende Körper wurde als Kathode geschaltet.

Die der Erfindung zugrundeliegende Aufgabe wird schließlich durch die Verwendung des erfindungsgemäßen Werkzeuges für die zerspanende Bearbeitung von harten Werkstoffen, insbesondere von harten Eisen- und Stahlwerkstoffen, gelöst.

Nach der Erfindung ist es besonders vorteilhaft, das erfindungsgemäße Werkzeug als Schneidkörper für die Feinbearbeitung der genannten Werkstoffe einzusetzen.

Der Gegenstand der Erfindung wird nachfolgend anhand von Ausführungsbeispielen erläutert.

### Beispiel 1

In eine Vertiefung einer Hartmetallwendeschneidplatte, bestehend aus 94 Gew.-% Wolframcarbid und 6 Gew.-% Cobalt, der Form SNUN 120404 (Bezeichnung nach DIN 4987) wurde ein ca. 4 x 3 mm großes Inlay aus PCBN mit einem bei 800 °C schmelzenden Lot befestigt.

Diese Wendeschneidplatte wurde nach dem Puls-Plasma-CVD-Verfahren gemäß DE 38 41 730 und DE 38 41 731 unter folgenden Versuchsparametern mit Al₂O₃ beschichtet:

| | |
|---|---|
| Gasphasentemperatur: | 600 °C |
| Gasdruck: | 250 Pa |
| Gleichspannung: | - 550 V |
| Restspannung: | - 40 V |
| Pulsdauer: | 50 µs |
| Pulspause: | 80 µs |
| Beschichtungsdauer: | 2 h |

Eine nachfolgende Untersuchung der mit Al₂O₃ beschichteten-Wendeschneidplatte ergab, daß die gesamte Oberfläche der Wendeschneidplatte einschließlich des PCBN-Inlays mit einer 2 µm dicken, fest haftenden Schicht aus feinverteilten, polykristallinem Al₂O₃ der Alpha-Modifikation bedeckt war. Das eingelötete Inlay war nach dem Beschichtungsvorgang in unveränderter Lage fest mit dem Hartmetallträger verbunden.

An einem Stahl 50CrMo4 mit einer Rockwell-Härte von 56 HRC wurden mit der erfindungsgemäßen Wendeschneidplatte mit PCBN-Inlay Drehversuche im kontinuierlichen Schnitt im Vergleich mit gleichen, aber nicht mit Al₂O₃ beschichteten Wendeschneidplatten mit PCBN-Inlay unter folgenden Versuchsbedingungen durchgeführt.

| | |
|---|---|
| Schnittgeschwindigkeit | 130 m/min |
| Schnittiefe | 0,5 mm |
| Vorschub | 0,08 mm/U |

Die Drehversuche wurden beendet, wenn eine Verschleißmarkenbreite von 0,3 mm erreicht war.

Bei nicht mit Al₂O₃ beschichteten Wendeschneidplatten mit PCBN-Inlay wurde diese Verschleißmarkenbreite bereits nach 19 min erreicht, während die mit einem PCBN-Inlay versehenen und mit Al₂O₃ beschichteten Wendeschneidplatten erst nach einer Einsatzdauer von 48 man Verschleißmarken von 0,3 mm aufwiesen.

### Beispiel 2

Eine Wendeschneidplatte der Form SNUN 120408 (Bezeichnung nach DIN 4987), bestehend aus einem Hartmetall aus 94 % Wolframcarbid und 6 % Cobalt, wurde durch ein PVD-Verfahren mit einer 8 µm dicken Schicht aus CBN beschichtet und anschließend unter den in Beispiel 1 beschriebenen Versuchsbedingungen nach dem Puls-Plasma-CVD-Verfahren gemäß DE 38 41 730 und DE 38 41 731 mit Aluminiumoxid beschichtet.

Die nachfolgende Untersuchung der so beschichteten Wende-schneidplatte ergab, daß sich eine 2 µm dicke Schicht aus Al₂O₃ abgelagert hatte, die fest auf dem CBN haftete. Durch eine Röntgenbeugunganalyse wurde festgestellt, daß es sich um sehr fein verteiltes, polykristallines Aluminiumoxid der Alpha-Modifikation handelt.

Die erfindungsgemäße Wendeschneidplatte wurde anschließend in einem Zerspanungsversuch gemäß Beispiel 1 einem Vergleich mit einer gleichen, aber nicht mit Al₂O₃ beschichteten Wendeschneidplatte unterzogen.

Die Verschleißmarkenbreite von 0,3 mm ergab sich bei nicht mit Al₂O₃ beschichteten, also nur mit CBN beschichteten Wendeschneidplatten nach 20 min, während die erfindungsgemäße zusätzlich mit Al₂O₃ beschichtete Wendeschneidplatte erst nach 34 min Einsatzdauer eine entsprechende Verschleißmarke aufwies.

## Patentansprüche

1. Werkzeug mit verschleißfester Schneide aus kubischem Bornitrid (CBN) oder polykristallinem kubischem Bornitrid (PCBN), wobei die Oberfläche des Werkzeuges CBN oder PCBN aufweist,
**dadurch gekennzeichnet,**
daß eine sich ganz oder teilweise über das Werkzeug erstreckende geschlossene CBN- oder PCBN-Schicht mit einer dünnen Schicht aus einem oder mehreren Metalloxiden überzogen ist.

2. Werkzeug mit verschleißfester Schneide aus CBN oder PCBN nach Anspruch 1, dadurch gekennzeichnet, daß die Oxid-Schicht 0,5 bis 6 µm, vorzugsweise 1 bis 3 µm, und/oder die CBN- oder PCBN-Schicht 10 mm dick ist und/oder feinkristallin und/oder rißfrei ist.

3. Werkzeug mit verschleißfester Schneide aus CBN oder PCBN nach einem der Ansprüche 1 oder 2, dadurch gekennzeichnet, daß die Oxid-Schicht aus mindestens einem Oxid der Metalle Magnesium und/oder Yttrium und/oder Titan und/oder Zirkonium und/oder Aluminium besteht.

4. Werkzeug mit verschleißfester Schneide aus CBN oder PCBN nach einem der Ansprüche 1 bis 3, dadurch gekennzeichnet, daß die Oberfläche aus CBN oder PCBN nur an den durch Verschleiß beanspruchten Stellen mit der Oxid-Schicht bedeckt ist und/oder daß die Oxid-Schicht auf einen mindestens an einer Schneidkante mit CBN beschichteten Substratkörper aufgebracht ist.

5. Werkzeug mit verschleißfester Schneide aus CBN nach einem der Ansprüche 1 bis 4, dadurch gekennzeichnet, daß der Substratkörper keine Zwischenschicht oder mindestens eine CBN-freie Zwischenschicht aufweist.

6. Werkzeug mit verschleißfester Schneide aus CBN oder PCBN nach einem der Ansprüche 1 bis 5, dadurch gekennzeichnet, daß die Oxid-Schicht auf einem PCBN-Einsatz (Inlay) oder auf einem massiven Körper aus PCBN (Monoblock) aufgebracht ist.

7. Werkzeug mit verschleißfester Schneide aus CBN oder PCBN nach einem der Ansprüche 1 bis 6, dadurch gekennzeichnet, daß die Oxid-Schicht aus mehreren aufeinanderfolgenden Schichten mindestens eines Oxides der Metalle Magnesium und/oder Yttrium und/oder Titan und/oder Zirkonium und/oder Aluminium bestehe.

8. Verfahren zur Herstellung eines Werkzeuges mit verschleißfester Schneide aus CBN oder PCBN nach einem der Ansprüche 1 bis 7, dadurch gekennzeichnet, daß die Oxid-Schicht aus der Gasphase bei niedrigen Gasphasentemperaturen abgeschieden wird, vorzugsweise bei einer Gasphasentemperatur bis zu 800 °C, weiterhin vorzugsweise zwischen 400 °C bis 600 °C beträgt.

9. Verfahren nach Anspruch 8, dadurch gekennzeichnet, daß das nach dem Stand der Technik bekannte Puls-Plasma-CVD-Verfahren zur Abscheidung der Oxidschicht verwendet wird.

10. Verwendung des Werkzeuges mit verschleißfester Schneide aus CBN oder PCBN nach einem der Ansprüche 1 bis 9 als Schneidkörper zur spanenden Bearbeitung, vorzugsweise Feinbearbeitung, von harten Werkstoffen, insbesondere harten Eisen- und Stahlwerkstoffen.

## Claims

1. Tool with wear-resistant cutting edge of cubic boron nitride (CBN) or polycrystalline cubic boron nitride (PCBN), whereby the surface of the tool has CBN or PCBN crystals, characterized in that a continuous layer of CBN or PCBN covering the tool entirely or partially is coated with a thin layer of one or more metal oxides.

2. Tool with wear-resistant diamond cutting edge according to claim 1, characterized in that the oxide layer has a thickness between 0.5 and 6 µm, preferably 1 to 3 µm and/or the CBN or PCBN layer has a thickness of 10 mm and/or is fine crystalline and/or free of cracks.

3. Tool with wear-resistant cutting edge of CBN or PCBN according to one of claims 1 to 2, characterized in that the oxide layer consists of at least one oxide of the metals magnesium and/or yttrium and/or titanium and/or zirconium and/or aluminum.

4. Tool with wear-resistant cutting edge of CBN or PCBN according to one of claims 1 to 3, characterized in that the surface of CBN or PCBN is covered by the oxide layer only in the areas where it is subjected to wear and/or that the oxide layer is applied to a substrate body coated with CBN on at least one cutting edge.

5. Tool with wear-resistant cutting edge of CBN according to one of claims 1 to 4, characterized in that the substrate body has no intermediate layer or at least one CBN-free intermediate layer.

6. Tool with wear-resistant cutting edge of CBN or PCBN according to one of claims 1 to 5, characterized in that the oxide layer is applied onto a PCBN insert (inlay) or onto a massive body of PCBN (monoblock).

7. Tool with wear-resistant cutting edge of CBN or PCBN according to one of claims 1 to 6, characterized in that the oxide layer consists of several successive layers of at least one oxide of the metals magnesium and/or yttrium and/or titanium and/or zirkonium and/or aluminum.

8. Process for manufacturing the tool with wear-resistant cutting edge of CBN or PCBN according to one of claims 1 to 7, characterized in that the oxide layer is deposited from the gas phase at low gas-phase temperatures up to 800°C, furthermore preferably the gas-phase temperature ranges between 400°C and 600°C.

9. Process according to claim 8, characterized in that the oxide layer is deposited by means of the pulse-plasma CVD process known to the state of the art.

10. Use of the tool with wear-resistant cutting edge of CBN or PCBN according to one of claims 1 to 9 as a cutting body in the chip-forming machining, preferably precision machining, of hard materials, particularly hard iron- and steel materials.

## Revendications

1. Outil à tranchant résistant à l'usure en nitrure de bore cubique (CBN) ou en nitrure de bore cubique polycristallin (PCBN), la surface de l'outil présentant du CBN ou du PCBN,
caractérisé par le fait
qu'une couche fermée en CBN ou en PCBN s'étendant sur l'outil tout entier ou en partie seulement est revêtue d'une couche mince composée d'un seul oxyde métallique ou de plusieurs oxydes métalliques.

2. Outil à tranchant résistant à l'usure en CBN ou en PCBN selon la revendication 1, caractérisé par le fait que la couche d'oxyde présente une épaisseur comprise entre 0,5 et 6 µm, et de préférence entre 1 et 3 µm, et / ou que la couche en CBN ou en PCBN présente de sa part une épaisseur de 10 mm et / ou qu'elle présente une structure en fins cristaux et / ou qu'elle est exempte de fissures.

3. Outil à tranchant résistant à l'usure en CBN ou en PCBN selon l'une des revendications 1 ou 2, caractérisé par le fait que la couche d'onde est composée d'au moins un oxyde des métaux tels que le magnésium et / ou le yttrium et / ou le titane et / ou le zirconium et / ou l'aluminium.

4. Outil à tranchant résistant à l'usure en CBN ou en PCBN selon l'une des revendications 1 à 3, caractérisé par le fait que la surface en CBN ou en PCBN n'est revêtue de la couche d'oxyde qu'aux endroits qui sont soumis à l'usure et / ou que la couche d'oxyde est appliquée sur un corps substrat dont au moins un tranchant est revêtu de CBN.

5. Outil à tranchant résistant à l'usure en CBN selon l'une des revendications 1 à 4, caractérisé par le fait que le corps substrat ne présente pas de couche intermédiaire ou qu'il présente du moins une couche intermédiaire exempte de CBN.

6. Outil à tranchant résistant à l'usure en CBN ou en PCBN selon l'une des revendications 1 à 5, caractérisé par le fait que la couche d'oxyde est appliquée sur un insert en PCBN (inlay) ou sur un corps massif en PCBN (monobloc).

7. Outil à tranchant résistant à l'usure en CBN ou en PCBN selon l'une des revendications 1 à 6, caractérisé par le fait que la couche d'oxyde se compose d'une succession de plusieurs couches d'au moins un oxyde des métaux tels que le magnésium et / ou le yttrium et / ou le titane et / ou le zirconium et/ou l'aluminium.

8. Procédé de fabrication d'un outil à tranchant résistant à l'usure en CBN ou en PCBN selon l'une des revendications 1 à 7, caractérisé par le fait que la couche d'oxyde est déposée directement de la phase gazeuse à de basses températures de phase gazeuse, et de préférence à une température de phase gazeuse allant jusqu'à 800 ° C, et au-delà de ce fait de préférence à une température comprise entre 400° C et 600° C.

9. Procédé selon la revendication 8, caractérisé par le fait que la couche d'oxyde est déposée par le biais du procédé CVD d'impulsions à plasma connu selon l'art antérieur.

10. Utilisation de l'outil à tranchant résistant à l'usure en CBN ou en PCBN selon l'une des revendications 1 à 9 en tant que corps de coupe pour usinage à enlèvement de copeaux, et de préférence pour finissage, de matériaux durs, de préférence de matériaux durs de fer et d'acier.
